# EUROPEAN PATENT APPLICATION

(11) **EP 2 892 070 A1**
(43) Date of publication of application: **08.07.2015**
(21) Application number: 13833401.6
(22) Date of filing: 21.08.2013
(51) Int. Cl.: H01H 33/59

(54) **OVERVOLTAGE SUPPRESSION METHOD AND DEVICE**

(30) Priority: 30.08.2012 JP 2012190024
(71) Applicant: Kabushiki Kaisha Toshiba, Minato-ku Tokyo 105-8001 (JP)
(72) Inventor: KOSHIZUKA, Tadashi, 105-8001 Tokyo (JP); MARUYAMA, Shiro, 105-8001 Tokyo (JP); SAITO, Minoru, 105-8001 Tokyo (JP); MATSUOKA, Hiroyuki, 105-8001 Tokyo (JP)
(74) Representative: Willquist, Sofia Ellinor
(86) International application number: PCT/JP2013/004927
(87) International publication number: WO 2014/034045

(57) **Abstract**

Current measurement means inputs single-phase current that is output from current measurement equipment and calculates (current measurement step) the current flowing in the ganged three-phase operation breaker when the ganged three-phase operation breaker interrupts the inductive load. Based on the measurement results of this current measurement equipment, phase detection means detects (phase detection step) a first interrupting phase selected from the three phases of the ganged three-phase operation breaker and the current interrupted point of this first interrupting phase. An open command output means sets a contacts-opening range between the time point obtained by back-calculation of the minimum arcing time for which current interruption is feasible without generating reignition and the current zero-point in the phase that is advanced by 120° phase from the first interrupting phase, starting from the current interrupted point as a base point, and outputs an open command to the three-phase breaker in this contacts-opening range (open command output step).

## Description

### FIELD

Embodiments described herein relate generally to an overvoltage suppression technique for suppressing overvoltage when cut-off of an inductive load is performed by a three-phase breaker.

### BACKGROUND

Typically, when a breaker interrupts an inductive load such as that of a reactor, arcing is produced between the opened contacts. In this process, depending on the length of the arcing time from generation of the arc until it is extinguished, a current zero-point may occur prior to the current zero-point that is the target of the breaker and reignition of the breaker may therefore take place. If reignition of the breaker takes place, high-frequency overvoltage is generated, which may threaten the integrity of the insulation of the equipment.

Methods of suppressing overvoltage by controlling the time point of contacts-opening of the breaker have therefore been previously proposed.

For example, in IEEE Transaction on Power Delivery, Vol.18, No.2, April 2003 "Application of Controlled Switching to 500-kV Shunt Reactor Current Interruption" (hereinafter referred to as Non-patent Reference 1), the following method of suppressing overvoltage is disclosed.

Specifically, the current zero-point at which interruption should take place is specified and the minimum arcing time required for interrupting the current without reignition is obtained by back-calculation from this specified current zero-point. This minimum arcing time is measured beforehand.

It is then arranged to supply an open command to the breaker so as to open the contacts during the period between the starting time point of the minimum arcing time and the current zero-point occurring immediately prior to the specified current zero-point.

In this way, by controlling the time point of contacts-opening of the breaker, it is possible to prevent a current zero-point from arising before the current zero-point at which interruption ought to take place. In this way, reignition of the breaker is prevented, so generation of overvoltage can be avoided.

The conventional overvoltage suppression method is applied to breakers of the individual-phase operating type, which operate individually on each phase. However, regarding the type of breaker, three-phase breakers are known which operate jointly on three phases, rather than operating individually on each phase. In such a three-phase breaker, three breaking units for the U phase, V phase and W phase respectively are operated by a single operating mechanism, so the breaking units of the three phases can be actuated simultaneously by a single open command.

Consequently, when this conventional overvoltage suppression method is applied to a ganged three-phase operation breaker, even if no current zero-point has arisen prior to the current zero-point at which interruption ought to take place in a given breaking unit of the three phases, it can still happen that, in the breaking unit of another phase, a current zero-point may arise prior to the current zero-point at which interruption ought to take place. This presented the risk of reignition of the breaker, with generation of a large overvoltage. As described above, it was thus considered difficult to prevent generation of overvoltage resulting from reignition in a three-phase breaker.

According to an aspect of the present technology, an object of the present embodiment is to provide an overvoltage suppression method and device aimed at solving the above problem whereby generation of overvoltage can be suppressed by controlling the contacts-opening time point when interrupting an inductive load with a three-phase breaker.

In order to achieve the above object, an overvoltage suppression method according to the present embodiment is constituted as follows.

Specifically, an overvoltage suppression method arranged to suppress generation of overvoltage caused by reignition in a three-phase breaker as described above when the inductive load of a three-phase breaker which is arranged between a power source and an inductive load is interrupted, is characterized in that it includes:
(a) a current measurement step of measuring the current flowing in said three-phase breaker when said three-phase breaker interrupts said inductive load;
(b) a phase detection step of detecting the first interrupting phase, of the three phases, and the current interrupted point of this first interrupting phase, based on the measurement results of the current measurement step referred to above;
(c) an open command output step in which a contacts-opening range is set between a time point obtained by back-calculation of the minimum arcing time for which current interruption is feasible without generating reignition, and the current zero-point in the phase which is advanced by 120° in phase from the first interrupting phase referred to above, starting from the aforementioned current interrupted point, and outputting an open command to the aforementioned three-phase breaker within this contacts-opening range.

In addition, an overvoltage suppression device according to this embodiment is constituted as a device for implementing the overvoltage suppression method described above.

### BRIEF DESCRIPTION OF THE DRAWINGS

FIG. 1 is a block diagram of a first embodiment;
FIG. 2 is a waveform diagram showing the relationship between breaker current and the time point of contacts-opening in this first embodiment; and
FIG. 3 is a waveform diagram showing the relationship between breaker current and the time point of contacts-opening in a second embodiment.

### DETAILED DESCRIPTION

### (1) First embodiment

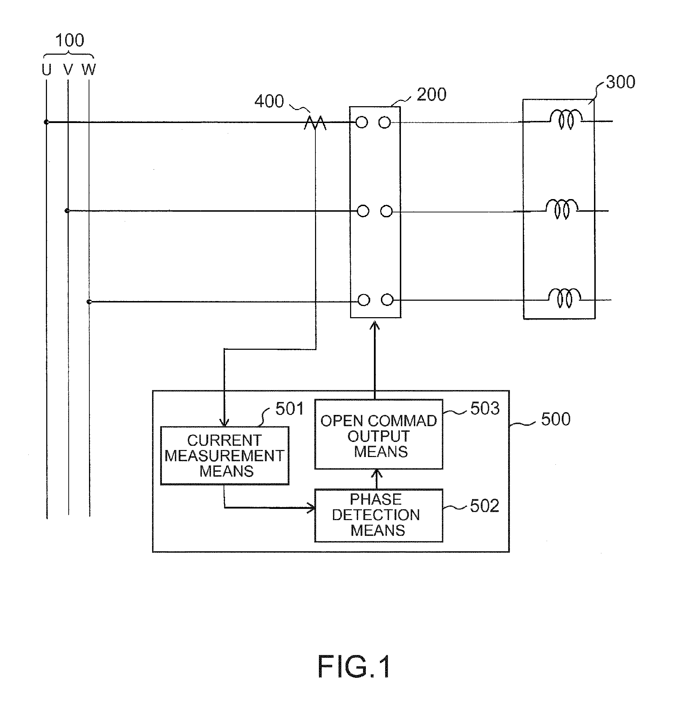

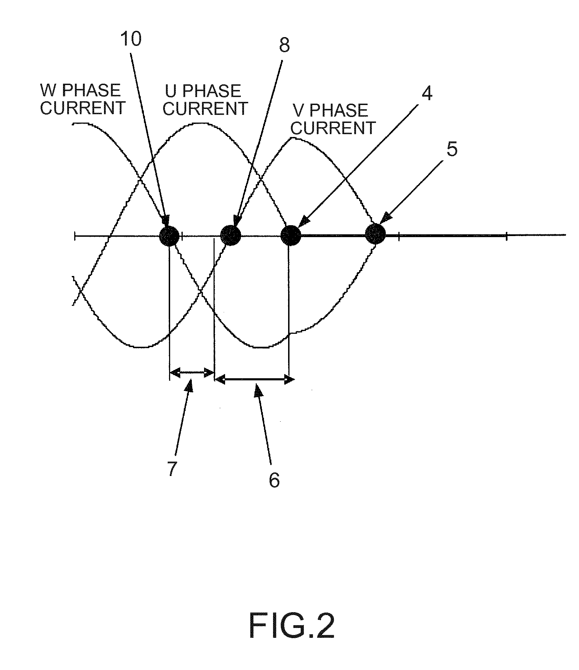

A first embodiment according to the present invention is described below with reference to FIG. 1 and FIG. 2. Identical portions are given the same reference symbols throughout the Figures to avoid repetition of description. FIG. 1 is a block diagram showing the connection relationship of a three-phase breaker (sometimes called three-phase breaker or ganged three-phase operation breaker) and inductive load, and an overvoltage suppression device for implementing the overvoltage suppression method. FIG. 2 is a waveform diagram showing the current waveform at the point where the current flowing in the inductive load is interrupted by the three-phase breaker, and also the contacts-opening time point.

### (Construction)

In FIG. 1, 100 is the power bus of a power system. An inductive load 300 such as a reactor is connected through a three-phase breaker 200 of simultaneous operation type to the power bus 100. The inductive load 300 is connected with or interrupted from the power bus 100 by the three-phase breaker 200. Although not shown in FIG. 1, the right-hand terminal of the inductive load 300 may be connected with a three-phase terminal, as in the case of a shunt reactor, or may be connected with a power transmission line for connection with another power bus, as in the case of a current-limiting reactor. In the case of a shunt reactor, the aforementioned connection point may either be earthed or not. For example, FIG. 2 shows an example waveform of three-phase current when the inductive load 300 is a shunt reactor and the right-hand terminal is assumed not to be earthed.

Current measurement equipment 400 is arranged between the power bus 100 and the three-phase breaker 200. The current measurement equipment 400 is an equipment that measures the current flowing through the three-phase breaker 200 and may, specifically, be for example an instrument current transformer CT (or only called a current transformer) or the like.

To the current measurement equipment 400 and three-phase breaker 200, there is connected an overvoltage suppression device 500 according to a first embodiment. The overvoltage suppression device 500 comprises: current measurement means 501; phase detection means 502; and open command output means 503.

The current measurement means 501 inputs single-phase current that is output from the current measurement equipment 400 and thus measures the current flowing in the three-phase breaker 200 when the three-phase breaker 200 cuts off the inductive load 300 (current measurement step). Based on the measurement results of the current measurement means 501, the phase detection means 502 detects the first interrupting phase selected from the three phases of the three-phase breaker 200 and detects the current interrupted point of this first interrupting phase (phase detection step) . In the example shown in FIG. 2, the U phase is assumed to be the first interrupting phase and the current zero-point at which the current of the U phase was interrupted is identified as the current interrupted point 4. Also, the currents of the V and W phase, other than the U phase, are interrupted at the current interrupted point 5.

The open command output means 503 sets a contacts-opening range for output of an open command to the three-phase breaker 200 and outputs an open command to the three-phase breaker 200 (open command output step). The open command output means 503 sets the contacts-opening range 7 shown in FIG. 2 as follows. Starting from the current interrupted point 4 of the first interrupting phase as a base point, the open command output means back-calculates the minimum arcing time 6, and sets the contacts-opening range as the period from this time point thus obtained by back calculation to the current zero-point 10 in the phase which is advanced by 120° in phase from the first interrupting phase. If the first interrupting phase is the U phase, the phase which is advanced by 120° in phase will be the W phase. It is a characteristic feature of the first embodiment that the contacts-opening range 7 is set in this way and an open command is output to the three-phase breaker in this contacts-opening range 7.

As mentioned above, the minimum arcing time 6 is the arcing time for which current interruption is feasible without reignition, and is obtained by measurement beforehand. If the contacts of the three-phase breaker are opened earlier in time than this minimum arcing time 6, interruption of the current of at least the first interrupting phase i.e. the U phase can be achieved without generating reignition at the time point of the current interrupted point 4.

However, since the current measurement means 501 inputs single-phase current that is output from the current measurement equipment 400, if we assume for example that this single-phase current that this current measurement means inputs is U phase current, the current measurement means 501 will be incapable of measuring the current waveform of the V phase and W phase. However, since the W-phase current is advanced by 120° in phase from the current waveform of the U phase, in fact, even without measuring the current of the W phase, so long as the current waveform of the U phase is known, the current waveform of the W phase can also be inferred, so the current zero-point 10 can easily be found. In the first embodiment, the contacts-opening range 7 can be set by determining the current zero-point 10 in this way.

Incidentally, it cannot be denied that, in closure of the three-phase breaker 200, there is some variability in contacts-opening time, caused by for example variability in the operation of the operating mechanism. However, by acquiring the characteristics thereof beforehand, the variability of the contacts-opening time of the three-phase breaker 200 can be compensated by a control device that performs phase control. The contents-opening range 7 of the three-phase breaker 200 can therefore be accurately set even in the presence of variability of the contacts-opening time.

### (Beneficial effect)

In FIG. 2, by performing contacts opening of the three-phase breaker 200 in the contacts-opening range 7, current interruption of the U phase can be achieved without generating reignition at the time point of the current interrupted point 4. Also, the current of the V and W phase, i.e. the phases other than the U phase, is interrupted at the current interrupted point 5. Of these, in the case of the W phase, there is no possibility of the current zero-point being passed through even once, after passage through the contacts-opening range 7. Current interruption can therefore be achieved at the time point of the current interrupted point 5 without reignition.

On the other hand, in the case of the V phase, as shown in FIG. 2, the current passes through the current zero-point 8 immediately after exiting the contacts-opening range 7. Consequently, reignition in the V phase may take place at the current zero-point 8. However, this passage through the current zero-point 8 takes place immediately after exiting the contacts-opening range 7, so the arcing time elapsing from the time point of contacts opening is extremely short. Speaking in general terms, it is known that, if the arcing time is short, the voltage between the contacts on reignition is small and the overvoltage is also small.

Consequently, even if reignition does take place in the V-phase at the current zero-point 8, overvoltage that is sufficiently large to threaten the integrity of the equipment insulation cannot be generated. In other words, the overvoltage that is generated by passage of the V phase through the current zero-point 8 is within an allowable range, so the V phase can be interrupted without finally generating overvoltage at the current interrupted point 5.

With this first embodiment described above, the contacts-opening range 7 is set from a time point obtained by back-calculation of the minimum arcing time 6, and an open command is output to the three-phase breaker 200 in this contacts-opening range 7. In this case, the current cannot pass through a current zero-point in either of the U phase or the W phase, so current cut-off can be achieved without reignition at time points of the current interrupted points 4 and 5.

Also, in the case of the W phase, albeit the current passes through the current zero-point 8 immediately after exiting the contacts-opening range 7, the arcing time is extremely short, so large overvoltage such as would threaten the integrity of the equipment insulation cannot be generated. Consequently, by permitting a small overvoltage at the current zero-point 8, generation of overvoltage by reignition can be suppressed in all phases of the three-phase breaker 200, making it possible to secure excellent reliability.

### (Second embodiment)

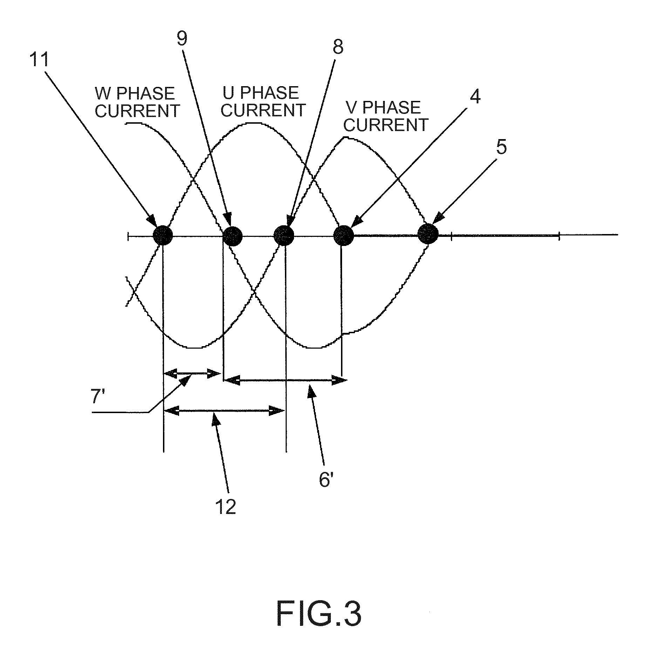

FIG. 3 is a view given in explanation of a second embodiment, and is a waveform diagram showing the current waveform and contacts-opening time point when the current flowing in the inductive load 300 is interrupted by a three-phase breaker 200. In this second embodiment, the connection layout of the three-phase breaker 200, inductive load 300 and overvoltage suppression device 500, and the layout of the overvoltage suppression device 500 are the same as in the case of the first embodiment shown in FIG. 1 and are therefore not illustrated.

### (Construction)

In the case of the open command output means 503 of the second embodiment, the range between the current zero-point 11, which is immediately prior to the current interrupted point 4, in the U phase, which is the first interrupting phase, and the current zero-point 8 in the V phase, which is the phase lagging by 120° phase from the U phase, which is the first interrupting phase, is designated as the contacts-opening setting range 12; the range that is within this contacts-opening setting range 12 but outside the minimum arcing time 6' of the first interrupting phase is set as the contacts-opening range 7'.

### (Beneficial effect)

In the second embodiment, after contacts-opening of the three-phase breaker 200, reignition occurs in the V phase after passing through the current zero-point 8. At the current zero-point 8, just as in the case of the first embodiment described above, there is no possibility of generation of a large overvoltage such as would threaten the integrity of insulation of the equipment.

On the other hand, depending on the minimum arcing time 6', the case may be envisioned where the contacts-opening time point is on the left-hand side in FIG. 3 of the W phase current zero-point 9. However, as explained above, if the arcing time is short, the voltage between the contacts in the event of reignition is small and the overvoltage is also small, so overvoltage that is sufficiently large to threaten the integrity of the insulation of the equipment is not generated even at the current zero-point 9. Consequently, the overvoltage that is generated by the W phase and V phase currents passing through the current zero-points 8 and 9 is within the allowed range, so the W phase and V phase can be interrupted without generating overvoltage at the final current interrupted point 5.

With the above second embodiment, even if a long minimum arcing time 6' is assumed, by outputting an open command to the three-phase breaker 200 within the contacts-opening range 7', generation of overvoltage due to reignition can be suppressed in all three phases.

### (Other embodiments)

It should be noted that the embodiments described are presented by way of example in the present specification and are not intended to restrict the scope of the invention. Specifically, the invention could be implemented in various other modes and various deletions or substitutions or alterations could be made without departing from the scope of the invention. Such embodiments or modifications are likewise included in the scope or gist of the invention and included in the scope of the invention and equivalents thereof set out in the patent claims.

## Claims

1. An overvoltage suppression method arranged to suppress generation of overvoltage caused by reignition in a ganged three-phase operation breaker when an inductive load of a ganged three-phase operation breaker which is arranged between a power source and an inductive load is interrupted, said overvoltage suppression method comprising:
a current measurement step of measuring a current flowing in said ganged three-phase operation breaker when said ganged three-phase operation breaker interrupts said inductive load;
a phase detection step of detecting a first interrupting phase, of three phases, and a current interrupted point of said first interrupting phase, based on measurement results of said current measurement step;
an open command output step in which a contacts-opening range is set between a time point obtained by back-calculation of a minimum arcing time for which current interruption is feasible without generating reignition, and a current zero-point in a phase which is advanced by 120° in phase from said first interrupting phase, starting from said current interrupted point as a base point, and outputting an open command to said ganged three-phase operation breaker within said contacts-opening range.

2. An overvoltage suppression method arranged to suppress generation of overvoltage caused by reignition in a ganged three-phase operation breaker when an inductive load of a ganged three-phase operation breaker which is arranged between a power source and an inductive load is interrupted, said overvoltage suppression method comprising:
a current measurement step of measuring a current flowing in said ganged three-phase operation breaker in a vicinity of when said ganged three-phase operation breaker interrupts said inductive load;
a phase detection step of detecting a first interrupting phase, of three phases, and a current interrupted point of said first interrupting phase, based on measurement results of said current measurement step;
an open command output step in which a contacts-opening range is set between a current zero-point, which is immediately prior to said current interrupted point t in said first interrupting phase, and a current zero-point in a phase lagging by 120° phase from said first interrupting phase but excluding a range, starting from current interrupted point as a base point, of a minimum arcing time, within which current interruption is feasible without generating reignition of said first interrupting phase.

3. An overvoltage suppression device arranged to suppress generation of overvoltage caused by reignition in a ganged three-phase operation breaker when an inductive load of a ganged three-phase operation breaker which is arranged between a power source and an inductive load is interrupted, said overvoltage suppression device comprising:
a current measurement means for measuring a current flowing through said breaker;
a phase detection means for detecting a first interrupting phase and a current interrupted point of said first interrupting phase, based on measurement results of said current measurement means;
an open command output section for setting a contacts-opening range from a time point obtained by back-calculation of a minimum arcing time for which current interruption is feasible without generating reignition, starting from said current interrupted point as a base point, and outputting an open command to said ganged three-phase operation breaker within said contacts-opening range.
